# EUROPÄISCHE PATENTSCHRIFT

(11) **EP 1 159 858 B1**
(45) Veröffentlichungstag und Bekanntmachung des Hinweises auf die Patenterteilung: **16.10.2002**
(21) Anmeldenummer: 00909050.7
(22) Anmeldetag: 21.02.2000
(51) Int. Cl.: H05K 13/00, H05K 13/04

(54) **VORRICHTUNG ZUM BESTÜCKEN VON SUBSTRATEN MIT ELEKTRISCHEN BAUELEMENTEN**
DEVICE FOR FITTING ELECTRIC COMPONENTS ON SUBSTRATES
DISPOSITIF PERMETTANT DE DEPOSER DES COMPOSANTS ELECTRIQUES SUR DES SUBSTRATS

(30) Priorität: 08.03.1999 DE 19910110
(43) Veröffentlichungstag der Anmeldung: 05.12.2001
(73) Patentinhaber: Siemens Dematic AG, 90475 Nürnberg (DE)
(72) Erfinder: MEHDIANPOUR, Mohammad, D-81829 München (DE)
(74) Vertreter: Berg, Peter
(86) Internationale Anmeldenummer: DE0000484
(87) Internationale Veröffentlichungsnummer: WO00054563

(56) Entgegenhaltungen:
- EP-A- 0 453 369
- WO-A-95/19099
- US-A- 5 002 448
- PATENT ABSTRACTS OF JAPAN vol. 018, no. 035 (E-1494), 19. Januar 1994 (1994-01-19) & JP 05 267896 A (YAMAHA MOTOR CO LTD), 15. Oktober 1993 (1993-10-15)

## Beschreibung

Die Erfindung bezieht sich auf eine Vorrichtung zum Bestücken von Substraten mit elektrischen Bauelementen, wobei die Substrate der Vorrichtung auf einer Transportstrecke zuführbar und in einem Bestückfeld fixierbar sind, wobei in Randbereichen der Vorrichtung Zuführeinrichtungen für die Bauelemente vorgesehen sind.

Eine derartige Vorrichtung ist z.B. durch die US 5,002,448 bekannt geworden. Danach ist die Transportstrecke durch die Vorrichtung hindurchgeführt und weist in einem zentralen Abschnitt das Bestückfeld auf. Zu beiden Seiten der Transportstrecke sind Zuführmodule aneinandergereiht, die mit ihren Abholplätzen der Transportstrecke zugewandt sind. Quer zur Transportstrecke erstrecken sich zwei Linearführungen für zwei zu diesen quer abstehende Positionierarme, entlang derer je ein Bestückkopf zum Handhaben der Bauelemente verfahrbar ist.

In einer Bestücklinie mit einer Reihe von verketteten Bestückvorrichtungen bedingt ein Typwechsel bei den Substraten einen großen Umrüstaufwand besonders bei den bereitzustellenden Bauelementen. Dieser Aufwand ist um so höher je größer die Anzahl der zu durchlaufenden Vorrichtungen ist. Eine Änderung der Substratbreite bedingt eine Änderung der Transportbreite bei allen Vorrichtungen. Aus diesem Grunde wird angestrebt, die Substrate von geringer Losgröße in möglichst wenigen Vorrichtungen komplett zu bestücken, was nur durch eine Ausweitung der bereitgestellten Bauteilevielfalt erreicht werden kann. Bei derartigen Anforderungen kann eine Einbuße bei der Bestückleistung in Kauf genommen werden.

Der Erfindung liegt die Aufgabe zugrunde, eine Vorrichtung zu schaffen, bei der eine größere Anzahl von Bauelementen im Zugriffsbereich des Bestückkopfes bereitgestellt werden kann.

Diese Aufgabe wird durch die Erfindung gemäß Anspruch 1 gelöst.Durch die Anordnung der Transportstrecke entlang einer Außenseite der Bestückvorrichtung sowie durch die Anordnung der Linearführung auf dieser Seite wird die Gesamtlänge der frei bleibenden Randzonen erheblich erhöht. Die Zuführmodule können nun entlang einer Längsseite und der beiden Stirnseiten der Vorrichtung angeordnet werden.

Die Substrate können mittels des Schlittens unter der Linearführung hindurch zum Bestückfeld verschoben werden und mit den auf drei Seiten bereitstehenden Bauelementen bestückt werden. Es versteht sich, daß die Länge der Linearführung und die Länge des Positionierarms so groß gehalten sind, daß sämtliche Abholstellen der Zuführmodule vom Bestückkopf erreicht werden können.

Nach einer vorteilhaften Weiterbildung der Erfindung sind in der Transportstrecke zwei hintereinander liegende Übergabestationen für zwei Schlitten vorgesehen, die zu zwei getrennten Bestückfeldern verschiebbar sind. Dadurch ist es möglich, die Substrate den Bestückfeldern im Wechselbetrieb zuzuführen und mit den Bauelementen zu bestücken, so daß sich der Zeitverlust für das Verschieben der Substrate minimiert.

Im folgenden wird die Erfindung anhand eines in der Zeichnung dargestellten Ausführungsbeispieles näher erläutert.

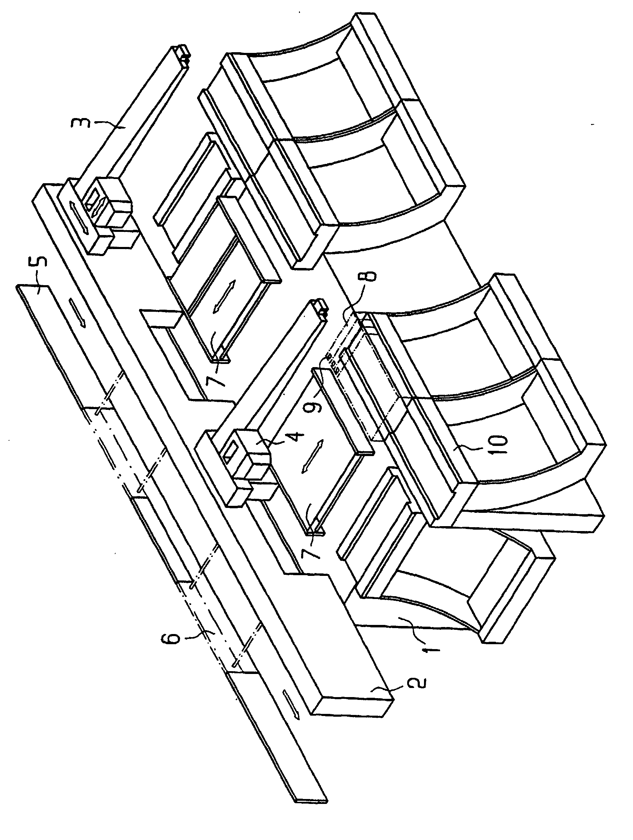

- Figur 1: zeigt schematisiert eine perspektivische Ansicht einer Vorrichtung zum Bestücken von Substraten mit elektrischen Bauelementen mit einer Transportstrecke.

Ein Chassis 1 der Vorrichtung weist einen im wesentlichen rechteckförmigen Grundriß auf. Entlang einer Längsseite ist auf dem Chassis 1 eine Linearführung 2 befestigt, an der quer abstehende Positionierarme 3 verfahrbar sind. Entlang dem Positionierarm 3 ist ein Bestückkopf 4 längsverschieblich geführt. Neben dem Chassis verläuft auf der Seite der Linearführung 2 eine lineare Transportstrecke 5 auf der nicht dargestellte Substrate in der Richtung des angegebenen Bewegungspfeils transportierbar sind.

Die Transportstrecke 5 weist zwei hintereinander liegende Übergabestationen 6 auf, in denen das Substrat auf einen zur Transportstrecke 5 quer verschiebbaren Schlitten 7 aufgelegt werden kann. Dieser kann durch einen Durchbruch unterhalb der Linearführung 2 zu einem Bestückfeld der Vorrichtung verschoben werden, in dem die aufliegenden Substrate mittels des Bestückkopfes 4 mit bereitgestellten Bauelementen bestückt werden können.

Die Bauelemente werden in scheibenartig aneinander gereihten Zuführmodulen 8 bereitgestellt, deren Abholplätze 9 dem Bestückfeld zugewandt sind. Die Zuführmodule sind auf Bauteiletischen 10 zusammengefaßt, die entlang der freien Seiten des Chassis 1 angeordnet sind. Auf der der Linearführung 2 gegenüberliegenden Seite des Chassis 1 sind hier vier und entlang der Stirnseiten zwei Bauteiletische angeordnet. Wodurch die Anzahl der Bauteiletische gegenüber einer herkömmlichen Vorrichtung verdreifacht ist.

Der Bestückkopf verfährt zwischen den Abholplätzen 9 und den Aufsetzstellen auf dem Substrat. Nach dem Ende des Bestückvorganges können die Schlitten 7 zu den Übergabestationen 6 zurückgeschoben werden und die Substrate der Transportstrecke 5 übergeben.

## Patentansprüche

1. Vorrichtung zum Bestücken von Substraten mit elektrischen Bauelementen,
wobei die Substrate auf einer Transportstrecke (5) zuführbar und in einem Bestückfeld der Vorrichtung fixierbar sind,
wobei in Randbereichen der Vorrichtung Zuführeinrichtungen (8) für die Bauelemente vorgesehen sind,
wobei entlang einer Linearführung (2) der Vorrichtung zumindest ein quer abstehender Positionierarm (3) verfahrbar ist,
wobei ein entlang dem Positionierarm verfahrbarer Bestückkopf (4) die Bauelemente an den Zuführeinrichtungen (8) aufnehmen und auf das Substrat aufsetzen kann,
**dadurch gekennzeichnet,**
**daß** die Transportstrecke (5) an einer Außenseite des Bestückfeldes vorbeigeführt ist, daß das Substrat in einer Übergabestation (6) der Transportstrecke (5) auf einen Schlitten (7) auflegbar ist,
**daß** der Schlitten (7) quer zur Transportstrecke (5) zum Bestückfeld verfahrbar ist,
**daß** das bestückte Substrat in der Übergabestation (6) der Transportstrecke übergebbar ist,
**daß** sich die Linearführung (2) entlang der Transportstrecke (5) auf derselben Seite der Vorrichtung erstreckt und
**daß** die Zuführeinrichtungen (8) entlang der der Linearführung (5) gegenüberliegenden Längsseite der Vorrichtung sowie entlang der dazu quer stehenden Stirnseiten der Vorrichtung angeordnet sind.

2. Vorrichtung nach Anspruch 1,
**dadurch gekennzeichnet,**
**daß** die Vorrichtung mit zwei in der Transportrichtung der Transportstrecke (5) hintereinanderliegenden Übergabestationen (6) versehen ist, von denen je ein Schlitten (7) zu je einem Bestückfeld verschiebbar ist.

## Claims

1. Device for fitting electrical components on substrates, it being possible for the substrates to be supplied on a transporting path (5) and fixed in a fitting zone of the device, feeding means (8) for the components being provided in edge regions of the device, at least one transversely protruding positioning arm (3) being able to travel along a linear guide (2) of the device, a fitting head (4) which can pick up components at the feeding means (8) and place them on the substrate being able to travel along the positioning arm, **characterized in that** the transporting path (5) is taken past an outer side of the fitting zone, **in that** the substrate can be placed on a carriage (7) in a transfer station (6) of the transporting path (5), **in that** the carriage (7) can travel transversely in relation to the transporting path (5) to the fitting zone, **in that** the substrate fitted with components can be transferred in the transfer station (6) to the transporting path, **in that** the linear guide (2) extends along the transporting path (5) on the same side of the device and **in that** the feeding means (8) are arranged along the longitudinal side of the device lying opposite the linear guide (5) and along the end faces of the device that are transverse thereto.

2. Device according to Claim 1, **characterized in that** the device is provided with two transfer stations (6) lying one behind the other in the transporting direction of the transporting path (5), from each of which stations a carriage (7) can be displaced to a respective fitting zone.

## Revendications

1. Dispositif pour équiper des substrats avec des composants électriques,
les substrats pouvant être amenés sur un trajet de transport (5) et pouvant être fixés dans un champ d'équipement du dispositif,
des systèmes d'amenage (8) pour les composants étant prévus dans des zones de bordure du dispositif,
au moins un bras de positionnement (3) écarté à la transversale pouvant être déplacé le long d'un guidage linéaire (2) du dispositif,
une tête d'équipement (4) déplaçable le long du bras de positionnement pouvant reprendre les éléments sur les systèmes d'amenage (8) et les déposer sur le substrat,
**caractérisé en ce que** le trajet de transport (5) passe le long d'un côté extérieur du champ d'équipement, **en ce que** le substrat peut être posé sur un chariot (7), dans un poste de transfert (6) du trajet de transport (5),
**en ce que** le chariot (7) peut se déplacer vers le champ d'équipement, à la transversale du trajet de transport (5),
**en ce que** dans le poste de transfert (6), le substrat équipé peut être transféré au trajet de transport,
**en ce que** le guidage linéaire (2) s'étend le long du trajet de transport (5), sur le même côté du dispositif et
**en ce que** les systèmes d'amenage (8) sont disposés le long du côté longitudinal du dispositif, lequel est opposé au guidage linéaire (5) et également le long des côtés frontaux du dispositif qui sont transversaux à ce dernier.

2. Dispositif selon la revendication 1,
**caractérisé en ce que** le dispositif est muni de deux postes de transfert (6) situés l'un derrière l'autre dans le sens de transport du trajet de transport (5), à partir desquels deux chariots (7) sont déplaçables chacun vers un champ d'équipement.
